# EUROPEAN PATENT APPLICATION

(11) **EP 2 348 342 A1**
(43) Date of publication of application: **27.07.2011**
(21) Application number: 11150318.1
(22) Date of filing: 06.01.2011
(51) Int. Cl.: G02B 6/00, H01L 31/052, F21V 8/00

(54) **Non-Tracked Low Concentration Solar Concentrator, Solar Concentrator Array and Waveguide Concentrator**

(30) Priority: 07.01.2010 US 683910
(71) Applicant: Sharp Kabushiki Kaisha, Osaka-shi, Osaka 545-8522 (JP)
(72) Inventor: Tillin, Martin David, Oxford Oxfordshire OX4 4GB (GB); Walton, Emma Jayne, Oxford Oxfordshire OX4 4GB (GB); Gass, Paul Antony, Oxford, Oxfordshire OX4 4GB (GB); Alet, Pierre-Jean, Oxford, Oxfordshire OX4 4GB (GB)
(74) Representative: Suckling, Andrew Michael

(57) **Abstract**

A low concentration solar apparatus for collecting solar radiation and concentrating it to a receiving device (16) such as a photovoltaic cell or thermovoltaic cell, comprising a non-tracked waveguide concentrator (14) with integral light turning element (12). It is thus possible to provide a solar apparatus for generating power in a very cost effective manner compared to conventional solar apparatus such as photovoltaic modules.

## Description

### FIELD OF THE INVENTION

The present invention relates to a solar apparatus for collecting solar radiation and concentrating it to a receiver such as a photovoltaic cell or thermovoltaic cell. More particularly, the invention relates to a solar concentrator, solar concentrator array, and waveguide concentrator.

### BACKGROUND OF THE INVENTION

Solar cells have great potential to meet the world's energy needs with zero carbon emissions, but they currently have a long pay-back period, and there is a great need to reduce the cost of power generation. The apparatus in accordance with the present invention aims to reduce the cost of solar panel manufacture by reducing the quantity of active solar cells per unit area compared to a conventional flat panel. This is achieved by concentrating the light from the sun into a smaller area than it would normally illuminate. There are many known ways to achieve this. Some methods require a mechanism for the solar panel or cell to track the sun and are able to deliver high concentration values. Other concentrating methods have been designed to work with solar panels that do not track the sun, but the resulting concentration factor that can be achieved is much lower. It is the aim of the apparatus in accordance with the invention to deliver a modest concentration factor through the use of an optical waveguide to concentrate the solar radiation, thus replacing expensive active solar cell material with a low cost optical waveguide.

The simplest type of optical waveguide concentrator is described in US 4,074,704 (Gellert, 1978) and US 4,344,417 (Malecek, 1982), which illustrate many designs of a wedge concentrator. Light is incident to a large surface of the wedge and collected at a smaller surface. The ratio of the areas of the surfaces gives the basic concentration factor of the device. Several designs are described including solid wedges or hollow ones designed to be filled with a fluid such as water. The radiation collected at the output face can be used to power a photovoltaic device or be used to heat water thermal solar device. The other surface of the wedge redirects the light by total internal reflection (TIR) or by a reflector placed on the outside of the surface. Designs are described which include smaller prisms (refracting devices) at the input face to increase the acceptance angle or concentration factor.

WO 2008/131561 A1 (Morgan, Morgan Solar, Inc., November 6, 2008) is similar in nature in that it uses an optical wedge-shaped waveguide to concentrate light at an input face to an exit face. The invention requires the use of optical elements formed between a light input surface and a first light output surface, and an optical waveguide coupled to the first light output surface and having a second output surface.

US 5646397 (Wenham, Unisearch Limited, 1997) describes a more advanced type of solar wedge concentrator which incorporates a flat reflector and a curved reflector. The solar cell is placed at the input surface and collects light that enters through the input surface and is reflected from the flat and curved surfaces onto the back of the solar cell. The flat reflector has facets to increase the acceptance angle of the device. Two wedges are used placed adjacent but with one rotated 180° with respect to the other. In this way light incident on the device is collected in one or other concentrator as it deviates from the normal to the devices.

US 6294723 (Uematsu, Hitachi, Ltd. 2001) describes an improved version of this device in which wedge concentrators of a very similar design are linked together. However the wedge concentrators are designed to have an asymmetric collection efficiency with respect to the normal to the light incident face. In this way the wedge concentrators can be optimized to work with a particular insolation angle range (the range of angles over which the sun will move during the course of a specified time period - for a year the sun will change it's zenithal inclination by about 46°). However, the invention requires the use of bi-facial solar cells to work well. If light is collected simply from the side of the cell that faces the reflecting surfaces of the prism then some light is lost or blocked at the incident surface. Using a bi-facial solar cell overcomes this problem, but at the expense of increased cost or lower overall efficiency.

### SUMMARY OF THE INVENTION

A first aspect of the present invention provides a solar concentration apparatus comprising: an optical waveguide with a light input face and a light output face which is substantially parallel to the light input face but displaced such that the two surfaces are not co-planar, the light output face being smaller than the light input face; the optical waveguide comprising at least one part that is shaped in a uniform wedge; the optical waveguide further comprising a light turning element; and a solar receiver. As used herein, a uniform wedge is defined as a wedge that has the same cross-section throughout its depth (meaning the orthogonal direction to the cross-section).

The solar receiver may be a photovoltaic cell, thermovoltaic cell or other thermal solar device.

The solar receiver may be attached directly to the light output face such that it is optically coupled to the light output face.

The light turning element may be a single reflective surface using total internal reflection or reflector on the exterior of the wedge concentrator. The single reflective surface may be flat or curved. Such a curved single reflective surface may comprise one or more radii of curvature. Alternatively the light turning element may comprise several surfaces for reflecting the light.

The solar concentration apparatus is designed to be positioned so as to receive and concentrate all light incident upon it during the day without the need to track the sun. In such a case the sun will traverse in a plane substantially perpendicular to the wedge cross-section. The solar concentration apparatus is also designed to be positioned so as to receive and concentrate the majority of light incident upon it during the year without the need to track the sun. In such a case the acceptance angle of the waveguide concentrator is designed to be less than or equal to 46° As used herein, an acceptance angle is defined as the angle within which light entering the device through the input face is guided/delivered to the output face (e.g., light incident on the input face at angles outside this angle range will not exit the device through the output face).

According to another aspect of this invention an array of waveguide solar concentrators may be formed together such that they are tiled with the thin end of one wedge concentrator lying adjacent to or overlapping the light turning element portion of an adjacent concentrator, such that there is no loss of aperture at the light input surfaces allowing 100% collection of all incident solar radiation. The solar receivers are arranged to be co-planar. The solar receivers can be attached directly to the output faces of the waveguide concentrator elements, or may be formed on a separate substrate and the waveguide concentrator assembly fixed on top of the array.

According to another aspect of this invention, the waveguide concentrator is designed to have a single light input face, but with many light output faces. The total area of the light output faces is less than the light input face. Each light output face is associated with a wedge shaped portion of the waveguide concentrator. One surface of each wedge shaped portion is designed to reflect incident light. Each light output face is also associated with at least one light turning element formed as part of the waveguide. All the light output faces are arranged to lie co-planar and parallel to the light input face. Each light output face is coupled to a solar receiver.

The solar receivers may be attached directly to the waveguide concentrator, and may be optically coupled to the light output faces.

The solar receivers may be formed on a separate substrate. The waveguide concentrator may be designed to be placed directly onto the solar receivers and positioned so that the active areas of the solar receivers are designed to align with, and be optically coupled to, the light output faces.

According to another aspect of the invention, the waveguide concentrator is made from a single sheet of glass.

According to another aspect of the invention, the waveguide concentrator is made from a single sheet of plastic.

According to another aspect of the invention, the waveguide concentrator incorporates a UV blocking filter to prolong the lifetime of the concentrator material.

According to another aspect of the invention, the waveguide concentrator is used as the front cover glass of a solar panel which serves a dual function of providing concentration of solar radiation as well as providing a barrier between the active solar receivers and the environment.

According to another aspect of the invention the solar concentration apparatus may be formed as at least part of a roof tile. Several such solar concentration apparatus may be easily combined to form a roof comprised of overlapping tiles. It is thus possible to provide a solar apparatus for collecting solar radiation and use it to generate power in a very cost effective manner compared to conventional solar panels such as photovoltaic modules. Compared to existing art the apparatus in accordance with the present invention provides a means of concentrating all of the incident solar radiation without loss of efficiency due to limited fill factor. In addition, a large area non-tracked solar concentrator can easily and cheaply be fabricated using discrete areas of active solar receiver and a single waveguide concentrator. In addition, the active solar receivers may be fabricated to lie co-planar, for example on a separate glass substrate, thus leading to a simple and cheap method of manufacturing an array of solar receivers.

According to one aspect of the invention, a waveguide concentrator includes: a wedge-shape optical waveguide including a light input face for receiving light and at least one light output face for outputting light, the light input face being on one side of the optical waveguide and the at least one light output face being on an opposite side of the optical waveguide, the light input face and at least one light output face being substantially parallel to each other and offset perpendicularly, wherein a surface area of the light input face is greater than a surface area of the at least one light output face; and at least one turning element coupling the light input face and the at least one light output face, the at least one turning element configured to turn light through an angle relative to a propagation direction of light in the waveguide.

According to one aspect of the invention, an angle of the light input face relative to the at least one light output face is less than 20 degrees.

According to one aspect of the invention, the wedge-shape optical wave guide includes a reflective surface on at least one side.

According to one aspect of the invention, the at least one light turning element is configured such that at least some light incident on the light input face directly impinges on the at least one light output face without being reflected in the waveguide.

According to one aspect of the invention, the at least one turning element is formed integral with the light input face and the at least one light output face.

According to one aspect of the invention, the at least one turning element comprises a single reflective surface.

According to one aspect of the invention, the reflective surface comprises a holographic element configured to redirect light propagating in the waveguide concentrator to the light output face.

According to one aspect of the invention, the reflective surface comprises a curved reflective surface.

According to one aspect of the invention, the curved reflective surface comprises at least two different radii.

According to one aspect of the invention, the reflective surface comprises both a curved reflective surface and flat reflective surface.

According to one aspect of the invention, the reflective surface comprises at least one flat surface.

According to one aspect of the invention, the at least one flat surface comprises a plurality of flat surfaces that are arranged at different inclinations relative to the light input face.

According to one aspect of the invention, the waveguide is configured to have an acceptance angle that is less than or equal to 46 degrees.

According to one aspect of the invention, the at least one light output face comprises a plurality of light output faces.

According to one aspect of the invention, a combined surface area of the plurality of light output faces is less than a surface area of the light input face.

According to one aspect of the invention, the waveguide comprises a plurality of wedge-shape portions, and each of the plurality of light output faces corresponds to a respective one of the plurality of wedge-shape portions.

According to one aspect of the invention, the waveguide comprises a plurality of turning elements, and each of the plurality of light output faces corresponds to a respective one of the plurality of turning elements.

According to one aspect of the invention, the waveguide concentrator comprises an ultra-violet blocking filter.

According to one aspect of the invention, the input face exhibits greater than 95 percent aperture ratio.

According to one aspect of the invention, a solar concentrator includes: the waveguide concentrator according to any one of the embodiments described herein; and a solar receiver optically coupled to the light output face.

According to one aspect of the invention, the solar receiver is at least one of a photovoltaic cell or a thermovoltaic cell.

According to one aspect of the invention, the solar receiver and the waveguide concentrator are formed on separate substrates.

According to one aspect of the invention, the solar concentrator is integrated within building materials.

According to one aspect of the invention, the solar receiver is directly coupled to the light output face.

According to one aspect of the invention, the solar receiver comprises at least two solar receivers electrically coupled to one another.

According to one aspect of the invention, a solar concentrator array includes a plurality of solar concentrators as set forth in any one of the embodiments described herein, wherein a waveguide of a first solar concentrator of the plurality of solar concentrators and a waveguide of a second solar concentrator of the plurality of solar concentrators are arranged relative to each other such that at least a portion of a light input face of the first solar concentrator is adjacent to a light turning element of the second solar concentrator.

According to one aspect of the invention, respective light input faces of the first and second solar concentrators are co-planar.

According to one aspect of the invention, at least part of the light turning element has an inclination to a plane of the light input face that is equal to or greater then an angle formed between the light input face and a side wall of the waveguide that is opposite the light turning device.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

Embodiments of the invention will be further described, by way of example, with reference to the accompanying drawings, in which:
Figure 1 is a cross-sectional diagram illustrating an embodiment of a solar concentration apparatus having a waveguide concentrator in accordance with the current invention in which a) depicts a wedge portion of the waveguide concentrator with flat surfaces and b) depicts a wedge portion of the waveguide concentrator with a curved surface;
Figure 2 is a cross-section illustrating some of the paths taken by radiation incident at a) normal to the waveguide concentrator and b) at an angle to the normal of the waveguide concentrator;
Figure 3 is a cross-section illustrating some of the paths taken by radiation incident at a) an angle to the normal to the waveguide concentrator and b) at another angle to the normal of the waveguide concentrator;
Figure 4 illustrates some alternative designs for a light turning element of a waveguide concentrator in accordance with the current invention in which the light turning element is a) a flat surface, b) more than one flat surface, c) a combination of flat and curved surfaces, d) a holographic element;
Figure 5 illustrates further alternative designs for the light turning element of a waveguide concentrator in accordance with the current invention in which the light turning element partially covers the area of the light output face and is a) a curved surface, b) a combination of flat and curved surfaces;
Figure 6 is a cross-sectional diagram illustrating a further embodiment of a waveguide concentrator in accordance with the current invention;
Figure 7 is a cross-sectional diagram illustrating a further embodiment of a waveguide concentrator in accordance with the current invention in which a) shows the principle of tiling waveguide concentrators and b) shows the principle of forming solar receiving devices co-planar on a substrate;
Figure 8 is a cross-sectional diagram illustrating a further embodiment of a waveguide concentrator in accordance with the current invention in which a) shows an alternative design of waveguide concentrator, b) shows the use of the waveguide concentrator in a solar concentrating apparatus and c) shows a possible path taken by radiation incident at the normal to the waveguide concentrator;
Figure 9 is a cross-sectional diagram illustrating a further embodiment of a waveguide concentrator in accordance with the current invention;
Figure 10 is a cross-sectional diagram illustrating electrical connections between a plurality of solar receiving units of a solar concentration apparatus in accordance with the current invention;
Figure 11 is a cross-sectional diagram illustrating a further embodiment of a solar concentrating apparatus in accordance with the current invention.

### DESCRIPTION OF THE EMBODIMENTS

The present invention will now be described with reference to the drawings in which like reference numerals are used to refer to like elements.

### Embodiment 1

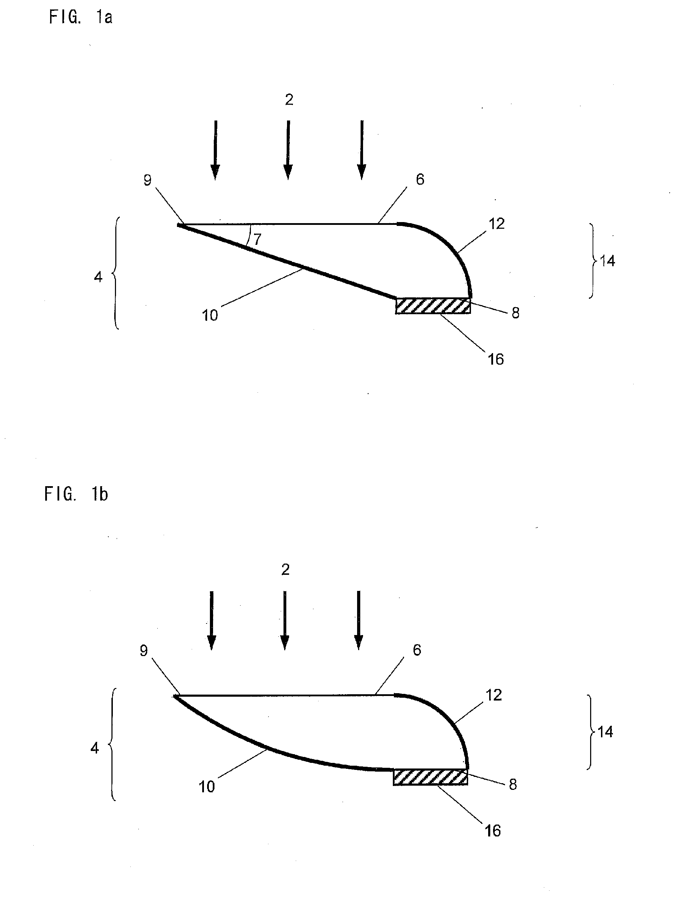

Figure 1a shows a cross-section of a solar concentration apparatus 4, comprising a waveguide concentrator 14 and a solar receiver 16 (e.g., a photovoltaic cell or a thermovoltaic cell). The waveguide concentrator comprises a light input face 6 for receiving incident radiation 2, a light output face 8 which is substantially parallel to the light input face 6 but displaced from each other in a direction perpendicular to the light output face (e.g., they are not co-planar with one another), a wedge portion 10 which tapers to a point 9 with a wedge angle 7, and at least one light turning element 12. As used herein, "substantially parallel" is defined as two faces or planes having an angle less than 20° and, more preferably, less than 10° relative to each other.

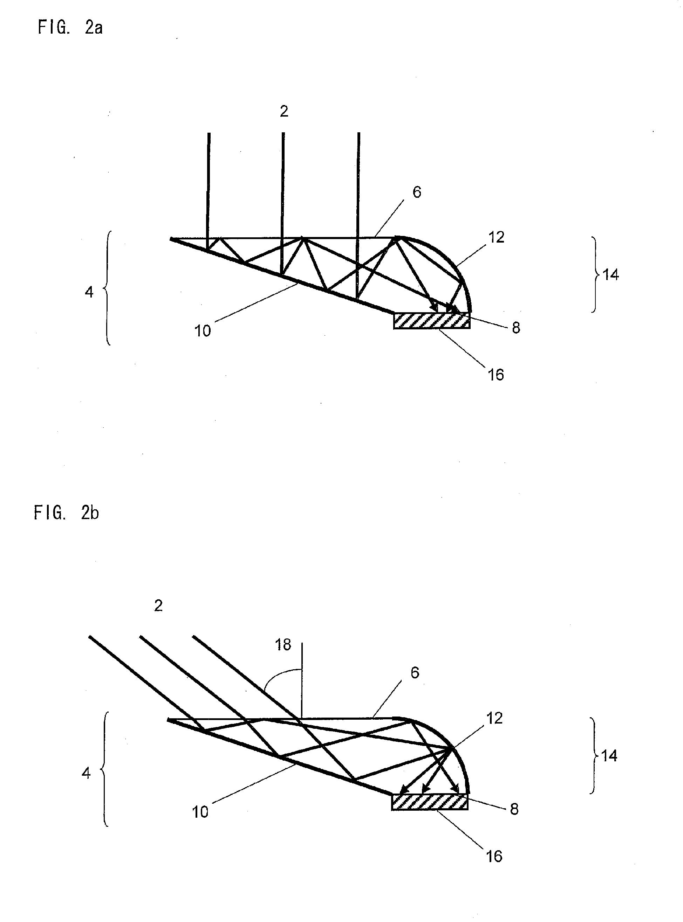

Incident radiation 2 illuminates the waveguide concentrator 14 as shown in figure 2a. The wedge portion 10 is designed to reflect light away from the point of the wedge 9, either by total internal reflection or through the use of a reflective surface placed on the long side of the wedge. The wedge angle 7 is designed such that normal incidence light that is reflected back towards the light input face 6 is totally internally reflected back into the waveguide concentrator 14. A light turning element 12 is formed in the end of the waveguide concentrator opposite to the point of the wedge 9. The purpose of the light turning element is to re-direct light towards the light output face 8. A light receiving device 16 is placed in optical contact with the light output face so as to receive all the light incident on the light input face. The area of the light output face 8 is smaller than the area of the light input face 6, such that light is concentrated to a higher intensity as it passes through the waveguide concentrator.

The wedge portion 10 may have flat (planar) surfaces as depicted figure 1a, or may have a curved surface as illustrated in figure 1 b.

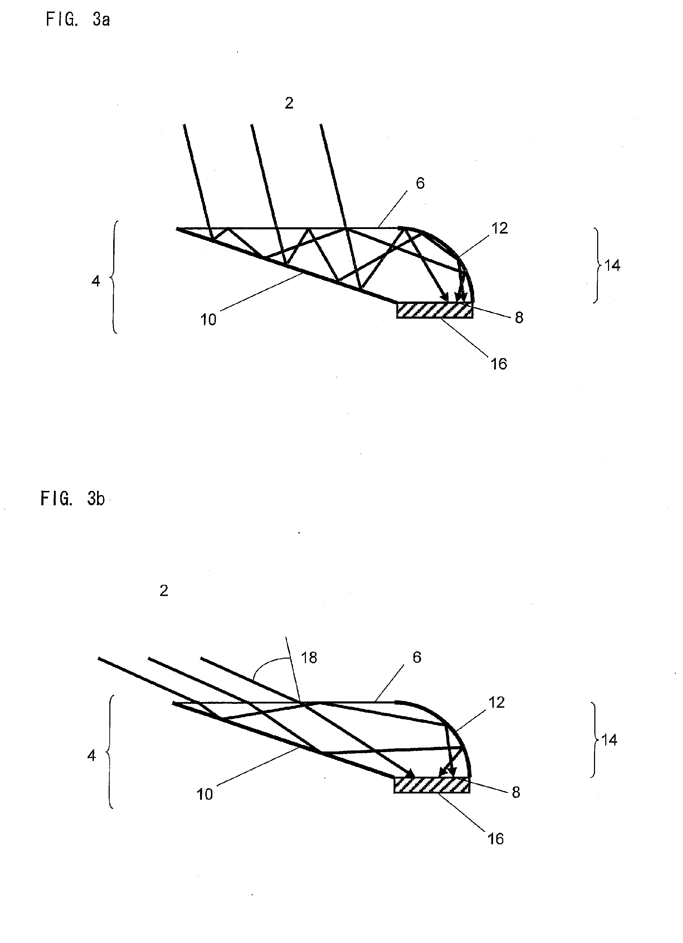

The solar concentrator apparatus is designed to work for a range of solar insolation. The solar concentrator apparatus is designed to be arranged such that the sun tracks in a plane which is orthogonal to the cross-section shown in figure 2b. During the year the sun's inclination to the earth changes by about 46° due to the tilt of the earth's axis. The solar concentration apparatus is designed so as to receive solar radiation for the majority of the year as shown in figure 2b such that the wedge concentrator concentrates all radiation incident on the light input surface 6 to the light output surface 8 over the range of incident angles 18. Preferably, an acceptance angle of the waveguide concentrator 14 is designed to be less than or equal to 46 degrees. It is possible to design the waveguide concentrator so that the angle range 18 need not be measured from normal incidence to the light input face as shown in figures 3a and 3b.

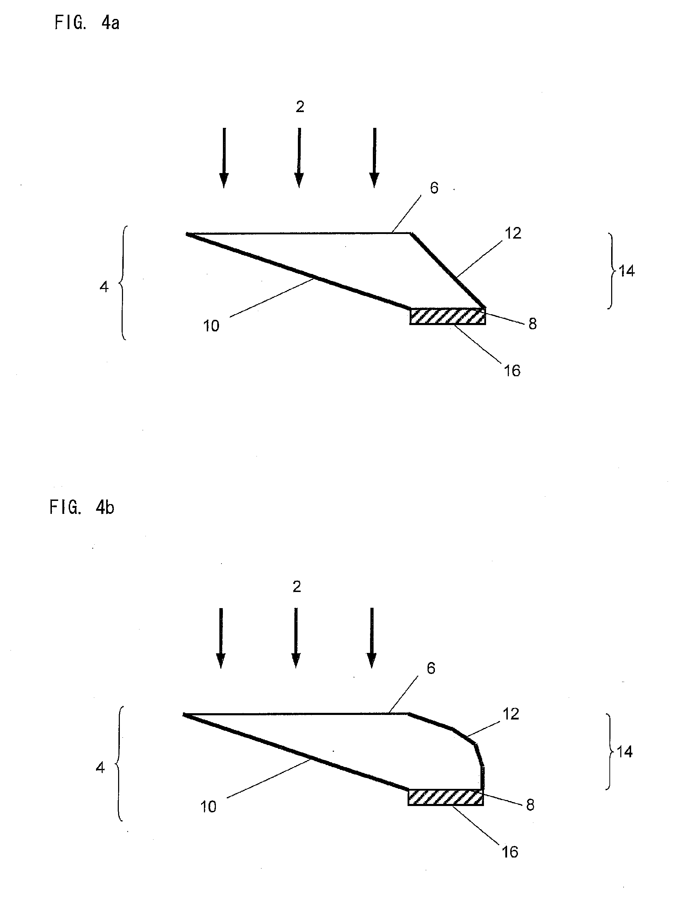

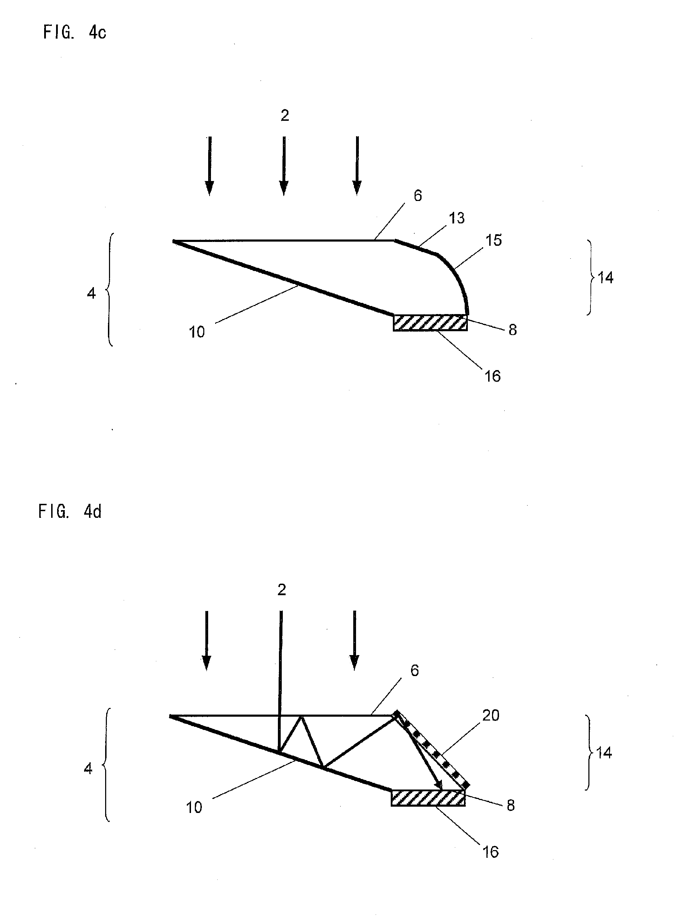

The light turning element 12 shown in figure 1 is represented as a curved surface with a uniform radius of curvature and which is coated with a reflective coating. However a number of light turning elements are possible. For example figure 4a shows a light turning element 12 that comprises a flat surface coated with a reflective coating (rays inside the wedge concentrator are omitted for clarity). Better light turning efficiency can be achieved than a single flat surface by splitting the single flat surface into multiple flat surfaces with different inclinations to the light input face. For example, figure 4b shows a light turning element comprised of 4 flat surfaces. An alternative light turning element is shown in figure 4c which comprises a flat surface 13 and a curved surface 15, which may have a variable radius of curvature, both coated with a reflective coating. Instead of a flat surface 13 another curved surface with a different radius of curvature may be used (e.g., the curved reflective surface can have at least two different radii). Another light turning element is shown in figure 4d in which a holographic element 20 is used to redirect the light propagating in the waveguide concentrator towards the light output face 8. Other light turning elements such as diffraction gratings or refractive elements may also be used. A reflective coating may be applied in many different ways. For example, a metal may be evaporated directly onto the surface to be coated, alternatively a reflective film such as the 3M ESR may be applied to the surfaces, alternatively a reflective coating may be achieved during the manufacturing process such as injection moulding.

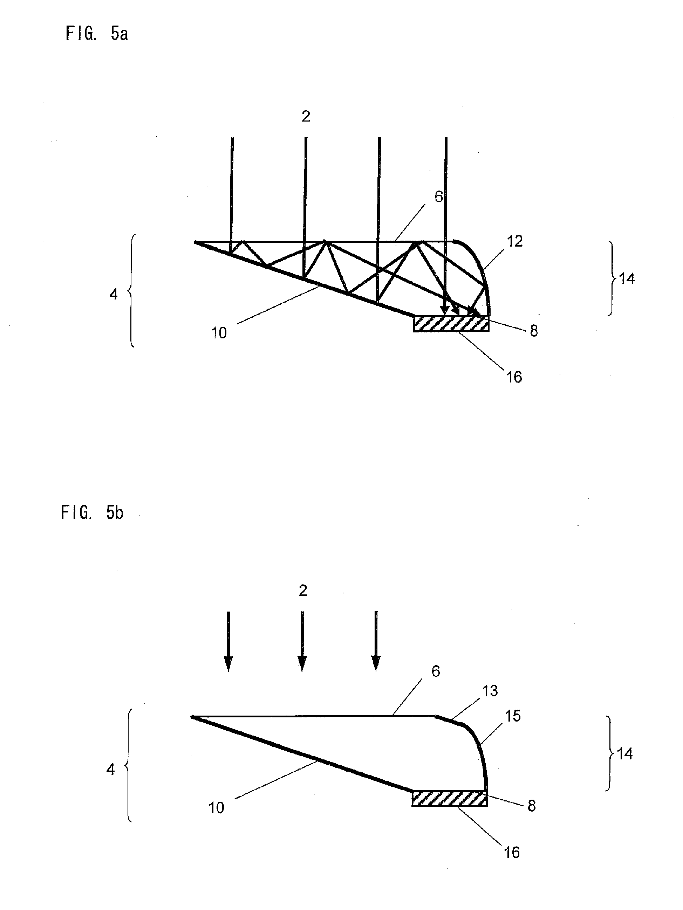

The figures 1-4 all show the light turning element 12 as blocking incident radiation 2 from directly impinging on the solar receiving device 16. However, this need not be the case as shown in figure 5a. The light turning element 12 only partially obscures the solar receiving device at normal incidence allowing some radiation to fall directly onto the solar receiving device without being reflected within the wedge concentrator. The light turning element 12 is depicted as a curve but it could equally be formed by any of the methods described hereinbefore. Figure 5b shows the same situation as depicted in figure 5a but with the light turning element 12 comprising a flat portion 13 and a curved portion 15.

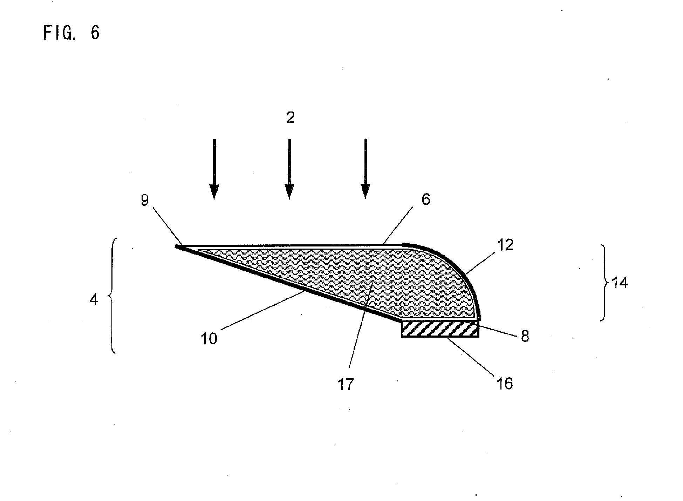

The waveguide concentrator 14 may be made of a solid material such as glass or plastic as shown in figure 1, or it may be made hollow as shown in figure 6 and filled with a liquid 17 such as water to perform the light collection and concentration function. The dimensions of the waveguide concentrator have to be designed to match the refractive index of the material from which the concentrator is made. It is desirable to use as high a refractive index as possible in order to achieve the highest concentration factor possible, as a higher refractive index allows for a smaller wedge angle 7 and a correspondingly higher geometrical concentration factor (which is equal to the ratio of the area of the light input face 6 to the light output face 8).

A small solar concentration apparatus was fabricated to prove the principles herein described, and to compare the measured performance to theoretical prediction from ray tracing software. A waveguide concentrator 14 as shown in figure 4b was made by cutting and polishing an acrylic block such that the light input face 6 had dimensions 69mm x 52mm and the light output face 8 had dimensions 24mm x 52mm and the wedge angle was about 19°. The geometrical concentration factor is 2.875. A polysilicon solar cell was used as the solar receiving device 16 and was attached to the light output face 8 by means of refractive index matching glue. Highly reflective surfaces were attached to the long surface of the wedge and the light turning element 12. Due to the finite size of the waveguide concentrator reflective surfaces were also applied to the sides of the waveguide concentrator, as defined in the cross-section of figure 1; in a full-sized solar concentration apparatus it is expected that the extent of the waveguide concentrator in the direction perpendicular to the cross section shown in figure 1 would be much larger than in this proof of principle test. Optical simulation was performed with the ray tracing package ZEMAX and the prediction was that for a simulated solar spectrum a concentration factor of approximately 2.1 would be achieved. The device described hereinbefore was measured in a solar simulator apparatus and the output of the solar cell compared to a solar cell which was not connected to a waveguide concentrator. The ratio of the power obtained from the solar concentration apparatus to the power obtained from the solar cell was 1.9. This is very close to the theoretical prediction, allowing for variations in efficiency of different solar cells, change of efficiency with illumination intensity and flaws in the reflective coatings of the waveguide concentrator. Much higher concentration factors may be achieved with some of the other designs described in this invention.

### Embodiment 2

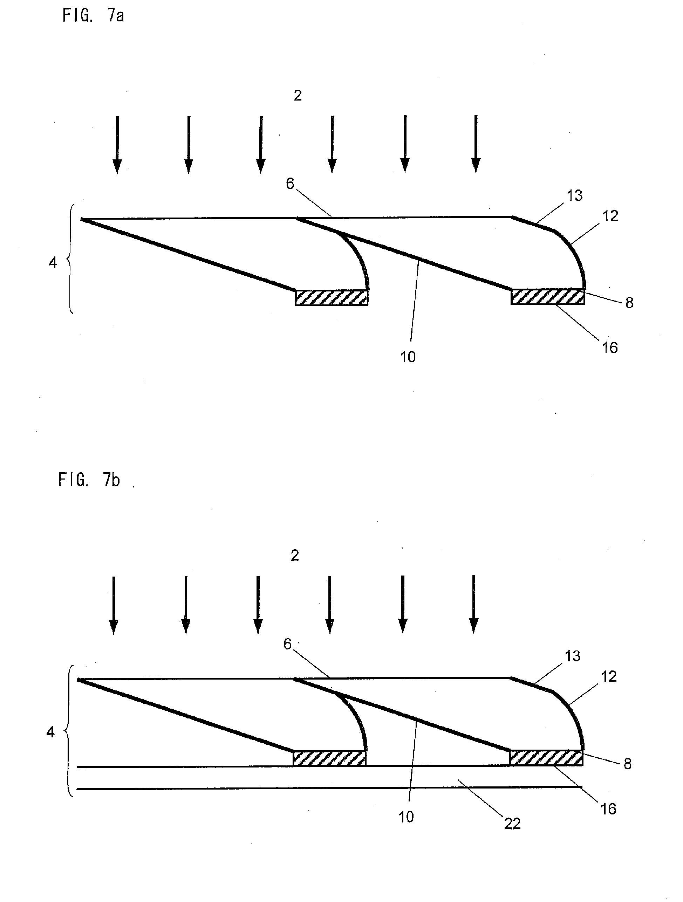

The solar concentration apparatus 4 shown in figure 1 may not be practical to scale up to very large area of solar receiving device 16, due to the increase in size, thickness and weight that might result. Therefore, a solar concentration apparatus may be formed by tiling several waveguide concentrators and solar receiving devices together as illustrated in figure 7a, which depicts 2 waveguide concentrators tiled together. For adjacent solar concentration apparatus to be tiled with no loss of light input face aperture, at least part 13 of the light turning element 12 must have an inclination to the plane of the light input face that is equal to or greater than the wedge angle 7. By tiling the solar concentration apparatus in this way it is possible to construct a large area of solar concentration apparatus with a greater then 95% aperture ratio, yet maintain a thin and lightweight form to the apparatus.

For example, a solar concentration apparatus may have a plurality of solar concentrators (e.g., a first solar concentrator and a second solar concentrator). A waveguide of the first solar concentrator and a waveguide of the second solar concentrator are arranged relative to each other such that at least a portion of a light input face of the first solar concentrator is adjacent to a light turning element of the second solar concentrator.

There is a further advantage of forming solar concentration apparatus in this way if the solar receiving devices 16 are kept co-planar. The solar receiving devices 16 may be formed together on a single large substrate 22. Once fabrication of the solar receiving devices is complete then the waveguide concentrators 14 may be placed on top of the solar receiving devices. In this way it is possible to simply and cheaply make a large area solar concentration apparatus.

### Embodiment 3

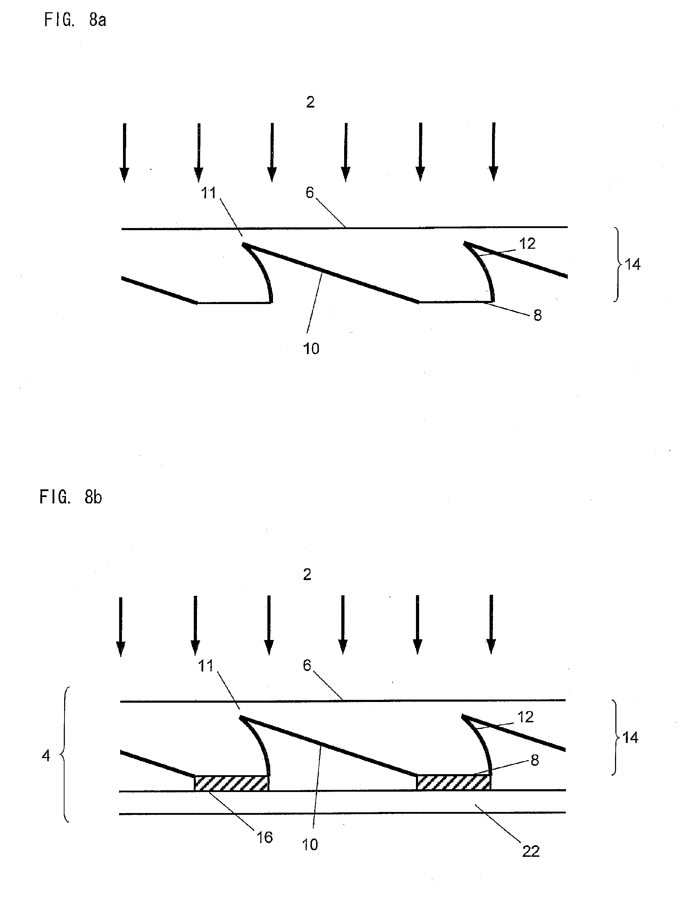

In order to further simplify fabrication of a large area version of the solar concentration apparatus described hereinbefore it is possible to make a version of the wedge concentrator which has a single light input face 6 but many light output faces 8. Such a design is shown in figure 8a which retains many of the features shown in figure 1 including a light input face 6, at least one light output face 8 displaced from the light input face 6 in a direction perpendicular to the light output face, at least one light turning element 12 and at least one uniform wedge portion 10. However, the wedge portion no longer tapers to a point as shown in figure 1, but each wedge portion is connected to an adjacent waveguide concentrator via a wedge connecting portion 11.

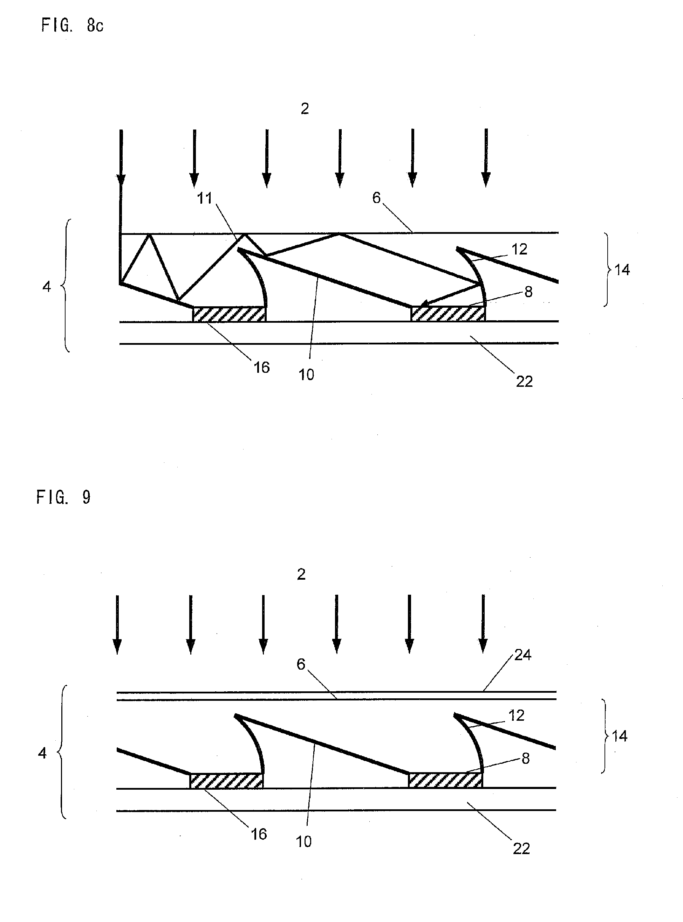

The waveguide concentrator may be used in a solar concentration apparatus as shown in figure 8b. Each light output face 8 is optically connected to a solar receiving device 16. An array of solar receiving devices may be formed co-planar onto a device substrate 22. Assembly of the solar concentration apparatus is eased by the use of a single waveguide concentrator which may simply be placed or fixed in optical contact with the solar receiving devices. Despite the fact that the long surface of the wedge 10 is now correspondingly shorter than in the designs described hereinbefore, this design suffers no loss of efficiency as illustrated in figure 8c. A single ray is traced inside the waveguide concentrator that would have been turned by the light turning element 12 of figure 1 towards the light output face 8 now misses the light turning element 12, but instead passes through the wedge connecting portion 11 into the adjacent wedge where it is turned by the light turning element associated with the adjacent wedge portion, and collected at the light output face associated with the adjacent wedge portion. The wedge connecting portion 11 should be a large enough proportion of the waveguide concentrator thickness to provide adequate stability to the waveguide concentrator.

The waveguide concentrator of this embodiment may be used to form the front protective cover plate of a solar panel.

If the waveguide concentrator is fabricated from plastic then it is advisable to use a highly UV resistant plastic to reduce degradation problems. Alternatively a protective film 24 may be applied to the waveguide concentrator as shown in figure 9 to form a UV blocking filter. The film may be designed to block UV radiation or may be a self-cleaning film to keep the light input face of the concentrator clean from dirt and grease. Alternatively a UV blocking material may be added directly to the material from which the waveguide concentrator is made so as to form a UV blocking filter. This applies to all embodiments described in this invention.

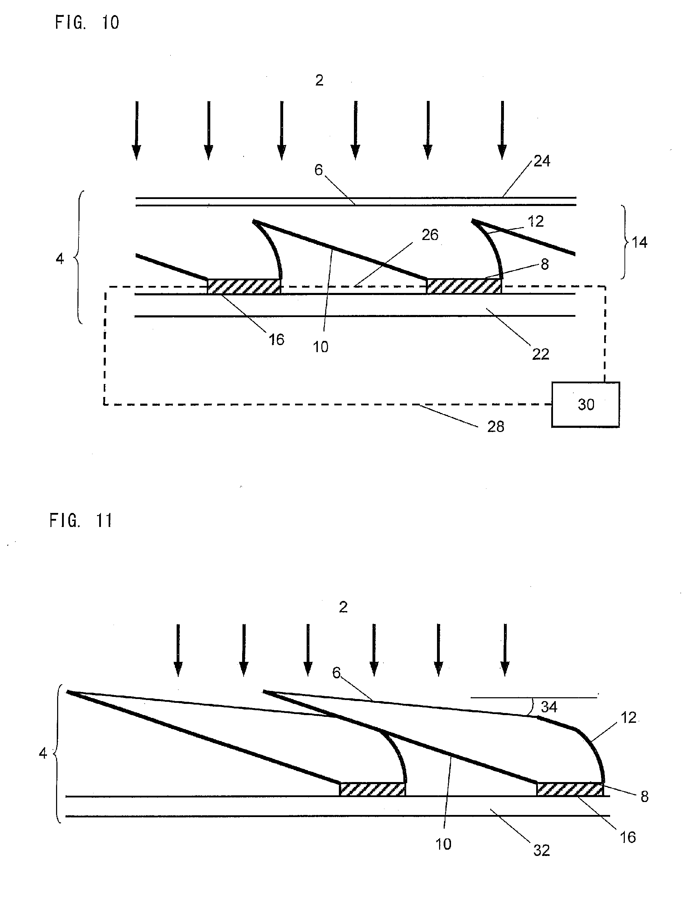

In describing specific embodiments in this invention, certain desirable features have been omitted for clarity. For example, no electrical or thermal connections between solar receiving units have been described, nor loads nor electrical converters have been described, but it is obvious to any ordinary person that such features would be required in order for the solar concentrating apparatus to function. In order to rectify this, an example is shown in figure 10 in which electrical connections 26 such as bus bars are shown between solar receiving devices 26 for conducting, in the case of solar cells, electricity. Connections 28 are also provided from the solar concentrating apparatus to external electronics such as inverters and electrical loads or storage devices 30. It is the intention that such features would be applied to all embodiments of this invention.

### Embodiment 4

The solar concentration apparatus hereinbefore described is primarily intended to be formed into a stand-alone apparatus that could be installed in a number of situations and applications. Such examples would be on rooftops or walls of houses or industrial buildings. The apparatus could be used as a portable power supply for example for powering devices in a motor home. The apparatus may also by used to power mobile electronic devices such as mobile phones and laptop computers if the solar waveguide is made at the appropriate scale.

The apparatus may also be used in building integrated photovoltaic systems. For example, the solar concentration apparatus may easily be used as roof tiles as illustrated in figure 11 (rotated for clarity). In other words, the solar concentration apparatus may be formed within building materials, such as roof tiles, siding, or the like. In this embodiment the wedge portion of the waveguide concentrator is designed to partially overlap with the waveguide concentrator of an adjacent solar concentration apparatus. In this case, the light input face 6 will no longer be parallel to the light output face, 8 and the wedge angle 7 will be smaller than that in embodiments hereinbefore described. Instead, the light input face 6 is inclined a small angle 34 to the plane of the light output face 8. The solar concentrator apparatus may be applied directly to the roof 32 to form tiles for the roof. Alternatively the solar concentration apparatus may be packaged into a more convenient form including substrates for the solar receiving apparatus and protective frames and covers.

Some embodiments of the present invention disclose a waveguide concentrator, wherein an angle of the light input face relative to the at least one light output face is less than 20 degrees.

Some embodiments of the present invention disclose a waveguide concentrator, wherein the at least one light turning element is configured such that at least some light incident on the light input face directly impinges on the at least one light output face without being reflected in the waveguide.

Some embodiments of the present invention disclose a waveguide concentrator, wherein the reflective surface comprises a holographic element configured to redirect light propagating in the waveguide concentrator to the light output face.

Some embodiments of the present invention disclose a waveguide concentrator, wherein the reflective surface comprises a curved reflective surface.

Some embodiments of the present invention disclose a waveguide concentrator, wherein the curved reflective surface comprises at least two different radii.

Some embodiments of the present invention disclose a waveguide concentrator, wherein the at least one planar surface comprises a plurality of planar surfaces that are arranged at different inclinations relative to the light input face.

Some embodiments of the present invention disclose a waveguide concentrator, wherein the waveguide is configured to have an acceptance angle that is less than or equal to 46 degrees.

Some embodiments of the present invention disclose a waveguide concentrator, wherein a combined surface area of the plurality of light output faces is less than a surface area of the light input face.

Some embodiments of the present invention disclose a waveguide concentrator, wherein the input face exhibits greater than 95 percent aperture ratio.

Some embodiments of the present invention disclose a solar concentrator, wherein the solar receiving device and the waveguide concentrator are formed on separate substrates.

Some embodiments of the present invention disclose a solar concentrator, wherein the solar receiving device is directly coupled to the light output face.

Some embodiments of the present invention disclose a solar concentrator array, wherein at least part of the light turning element has an inclination to a plane of the light input face that is equal to or greater then an angle formed between the light input face and a side wall of the waveguide that is opposite the light turning device.

It is the intention that the invention is not limited to the specific embodiments and examples given above, and that others will be obvious to anyone skilled in the art.

## Claims

1. A waveguide concentrator, comprising:
a wedge-shape optical waveguide including a light input face (6) for receiving light and at least one light output face (8) for outputting light, the light input face being on one side of the optical waveguide and the at least one light output face being on an opposite side of the optical waveguide, the light input face and the at least one light output face being substantially parallel to each other and offset perpendicularly, wherein a surface area of the light input face is greater than a surface area of the at least one light output face; and
at least one turning element (12) coupling the light input face and the at least one light output face, the at least one turning element configured to turn light through an angle relative to a propagation direction of light in the waveguide.

2. The waveguide concentrator according to claim 1, wherein the wedge-shape optical wave guide includes a reflective surface on at least one side.

3. The waveguide concentrator according to any one of claims 1-2, wherein the at least one turning element (12) is formed integral with the light input face (6) and the at least one light output face (8).

4. The waveguide concentrator according to any one of claims 1-3, wherein the at least one turning element (12) comprises a single reflective surface.

5. The waveguide concentrator according to claim 4, wherein the reflective surface comprises both a curved reflective surface and planar reflective surface.

6. The waveguide concentrator according to claim 4, wherein the single reflective surface comprises at least one flat surface.

7. The waveguide concentrator according to any one of claims 1-6, wherein the at least one light output face (8) comprises a plurality of light output faces.

8. The waveguide concentrator according to claim 7, wherein the waveguide comprises:
a plurality of wedge-shape portions (9), and each of the plurality of light output faces (8) corresponds to a respective one of the plurality of wedge-shape portions; and
a plurality of turning elements (12), and each of the plurality of light output faces (8) corresponds to a respective one of the plurality of turning elements.

9. The waveguide concentrator according to any one of claims 1-8, wherein the waveguide concentrator comprises an ultra-violet blocking filter.

10. A solar concentrator, comprising:
the waveguide concentrator according to any one of claims 1-9; and
a solar receiver (16) optically coupled to the light output face (8).

11. The solar concentrator according to claim 10, wherein the solar receiving device is at least one of a photovoltaic cell or a thermovoltaic cell.

12. The solar concentrator according to any one of claims 10-11, wherein the solar concentrator is integrated within building materials.

13. The solar concentrator according to any one of claims 10-12, wherein the solar receiver comprises at least two solar receivers electrically coupled to one another.

14. A solar concentrator array, comprising a plurality of solar concentrators as set forth in any one of claims 10-13, wherein a waveguide of a first solar concentrator of the plurality of solar concentrators and a waveguide of a second solar concentrator of the plurality of solar concentrators are arranged relative to each other such that at least a portion of a light input face of the first solar concentrator is adjacent to a light turning element of the second solar concentrator.

15. The solar concentrator array according to claim 14, wherein respective light input faces (6) of the first and second solar concentrators are co-planar.
